(19) Europäisches Patentamt
European Patent Office
Office européen des brevets

(11) **EP 4 693 903 A1**

(12) **EUROPEAN PATENT APPLICATION**

(43) Date of publication:
**11.02.2026 Bulletin 2026/07**

(21) Application number: **25190662.4**

(22) Date of filing: **21.07.2025**

(51) International Patent Classification (IPC):
**H03K 3/84** $^{(2006.01)}$          **G06F 7/58** $^{(2006.01)}$

(52) Cooperative Patent Classification (CPC):
**H03K 3/84; G06F 7/58**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **08.08.2024 US 202463680687 P**

(71) Applicant: **Extropic Corp.**
**Austin TX 78757 (US)**

(72) Inventors:
• **MCCOURT, Trevor Johnathan**
**Cambridge, 02139 (US)**
• **FREITAS, Jose Nahuel**
**Cambridge, 02139 (US)**
• **CHAMBERLAND, Christopher Abraham**
**Austin, 78748 (US)**

(74) Representative: **Piotrowicz, Pawel Jan Andrzej**
**Venner Shipley LLP**
**406 Cambridge Science Park**
**Milton Road**
**Cambridge CB4 0WW (GB)**

(54) **MANAGING ARRANGEMENTS OF TRANSISTORS IN CIRCUITS FOR GENERATING SAMPLES FROM A TARGET DISTRIBUTION**

(57)     An apparatus (300) comprises: one or more voltage sources; a plurality of transistor rails (301A-301C), each transistor rail of the plurality of transistor rails comprising a first transistor (302A-302C) connected to a first node (321A-312C) and a second node (314A-314C), a second transistor (304A-304C) connected to the first node, and a first capacitor (C1-C3) connected to the first node and the second node; wherein the first node of each transistor rail of the plurality of transistor rails is connected to a first node of two different respective transistor rails of the plurality of transistor rails by two different respective capacitors (C12, C13); wherein one or more voltage sources are configured to apply a respective set of voltages to each transistor rail of the plurality of transistor rails.

FIG. 3

EP 4 693 903 A1

**Description**

CROSS-REFERENCE TO RELATED APPLICATION(S)

This application claims priority to and the benefit of U.S. Provisional Application Serial No. 63/680,687, entitled "MANAGING ARRANGEMENTS OF TRANSISTORS IN CIRCUITS FOR GENERATING SAMPLES FROM A TARGET DISTRIBUTION," filed August 8, 2024.

TECHNICAL FIELD

This disclosure relates to managing arrangements of transistors in circuits for generating samples from a target distribution.

BACKGROUND

Integrated circuits (ICs) comprising interconnected components including resistors, transistors, and capacitors, can be used to build electronic devices capable of performing complex operations. Some IC devices can be utilized to build electronic devices that are capable of performing computations. Compact designs coupled with advances in mass production capabilities and technologies have contributed to the widespread adoption of ICs. Current implementations of IC devices can utilize metal-oxide-semiconductor (MOS) integrated circuits that can be built on chip platforms comprising silicon. Some IC devices can be built with complementary metal-oxide-semiconductors (CMOS) comprising semiconductors doped with elements to modify their associated physical properties.

SUMMARY

In one aspect, in general, an apparatus comprises: one or more voltage sources; a first transistor rail comprising a first transistor comprising a first terminal, a second terminal, and a third terminal, wherein the first terminal is connected to a first node and the second terminal is connected to a second node, a second transistor comprising a fourth terminal, a fifth terminal, and a sixth terminal, wherein the fourth terminal is connected to the first node, and a first capacitor connected to the first node and the second node; wherein a voltage source is configured to apply a first voltage, $V_1$, to the fifth terminal; wherein a voltage source is configured to apply a second voltage, $V_2$, to the sixth terminal; wherein a voltage source is configured to apply a third voltage, $V_3$, to the third terminal; wherein a voltage source is configured to apply a fourth voltage, $V_4$, to the second node; and wherein $V_1 + V_4$ is within 10% of $V_2 + V_3$.

Aspects can include one or more of the following features.

The first transistor is an n-type metal-oxide-semiconductor transistor and the second transistor is a p-type metal-oxide-semiconductor transistor. The apparatus further comprises a measurement circuit configured to measure one or more voltage differences between the first node and the second node.

The second voltage is lower than a threshold voltage of the second transistor and the third voltage is lower than a threshold voltage of the first transistor.

The apparatus further comprises a plurality of transistor rails including the first transistor rail, each transistor rail of the plurality of transistor rails comprising a first transistor comprising a first terminal, a second terminal, and a third terminal, wherein the first terminal is connected to a first node and the second terminal is connected to a second node, a second transistor comprising a fourth terminal, a fifth terminal, and a sixth terminal, wherein the fourth terminal is connected to the first node, and a first capacitor connected to the first node and the second node; wherein the first node of each of one or more transistor rails of the plurality of transistor rails is connected to a first node of each of two or more different respective transistor rails of the plurality of transistor rails by different respective capacitors.

The first node of each transistor rail of the plurality of transistor rails is connected to a first node of every other transistor rail of the plurality of transistor rails by different respective capacitors.

In another aspect, in general, an apparatus comprises: one or more voltage sources; a plurality of transistor rails, each transistor rail of the plurality of transistor rails comprising a first transistor connected to a first node and a second node, a second transistor connected to the first node, and a first capacitor connected to the first node and the second node; wherein the first node of each transistor rail of the plurality of transistor rails is connected to a first node of two different respective transistor rails of the plurality of transistor rails by two different respective capacitors; wherein one or more voltage sources are configured to apply a respective set of voltages to each transistor rail of the plurality of transistor rails.

Aspects can include one or more of the following features.

The first transistor comprises a first terminal connected to the first node, a second terminal connected to the second node, and a third terminal, the second transistor comprises a fourth terminal connected to the first node, a fifth terminal, and a sixth terminal, and a set of voltages applied to a transistor rail of the plurality of transistor rails comprises a first voltage applied to the first terminal, a second voltage applied to the sixth terminal, a third voltage applied to the third terminal, and a fourth voltage applied to the second node.

For each set of voltages, the second voltage is lower than a threshold voltage of the second transistor and the third voltage is lower than a threshold voltage of the first transistor.

The apparatus further comprises a plurality of measurement circuits, where each measurement circuit of the plurality of measurement circuits is configured to measure a voltage difference between a first node and second node of a respective transistor rail of the plurality of transistor rails.

Each first transistor of a transistor rail of the plurality of transistor rails is an n-type metal-oxide-semiconductor transistor and each second transistor of a transistor rail of the plurality of transistor rails is a p-type metal-oxide-semiconductor transistor.

In another aspect, in general, a method comprises: configuring one or more voltage sources; arranging a plurality of transistor rails, each transistor rail of the plurality of transistor rails comprising a first transistor comprising a first terminal, a second terminal, and a third terminal, wherein the first terminal is connected to a first node and the second terminal is connected to a second node, a second transistor comprising a fourth terminal, a fifth terminal, and a sixth terminal, wherein the fourth terminal is connected to the first node, and a first capacitor connected to the first node and the second node, wherein the first node of each transistor rail of the plurality of transistor rails is connected to a first node of each of two different respective transistor rails of the plurality of transistor rails by two different respective capacitors; and applying, to each transistor rail of the plurality of transistor rails, a respective set of voltages.

Aspects can include one or more of the following features.

A set of voltages applied a transistor rail of the plurality of transistor rails comprises a first voltage applied to the first terminal, a second voltage applied to the sixth terminal, a third voltage applied to the third terminal, and a fourth voltage applied to the second node.

For each transistor rail of the plurality of transistor rails, a difference of the first voltage applied to the first terminal and the fourth voltage applied to the second node is within 10% of a difference of the first voltage applied to the first terminal and the fourth voltage applied to the second node in each set of voltages applied to each other transistor rail of the plurality of transistor rails.

For each transistor rail of the plurality of transistor rails, the second voltage is lower than a threshold voltage of the second transistor and the third voltage is lower than a threshold voltage of the respective first transistor.

For each transistor rail of the plurality of transistor rails, a sum of the first voltage applied to the first terminal with the fourth voltage applied to the second node is within 10% of a sum of the second voltage applied to the sixth terminal and the third voltage applied to the third terminal.

The method further comprises measuring a plurality of voltage differences between the first node and the second node of each transistor rail of the plurality of transistor rails .

The method further comprises measuring a voltage difference between a first node and the second node of one transistor rail of the plurality of transistor rails while tuning the sets of voltages applied to each other transistor rail of the plurality of transistor rails.

Tuning the sets of voltages comprises applying, to each transistor rail of the plurality of transistor rails, a first voltage applied to the first terminal, a second voltage applied to the sixth terminal, a third voltage applied to the third terminal, and a fourth voltage applied to the second node.

The method further comprises measuring, at each first node of each transistor rail of the plurality of transistor rails, a voltage distribution. The voltage distribution is substantially Gaussian.

Aspects can have one or more of the following advantages.

Some implementations of disclosed herein can be utilized to generate samples from Gaussian distributions associated with physical behaviors arising from the hardware. Generating samples from Gaussian distributions using hardware devices can be faster and more energy efficient than generating samples via software implementations. Some hardware devices can also generate samples having distributions that more accurately reflect physical phenomena than other implementations.

Other features and advantages will become apparent from the following description, and from the figures and claims.

BRIEF DESCRIPTION OF THE DRAWINGS

The disclosure is best understood from the following detailed description when read in conjunction with the accompanying drawing. It is emphasized that, according to common practice, the various features of the drawing are not to-scale. On the contrary, the dimensions of the various features are arbitrarily expanded or reduced for clarity. The plots resulting from numerical simulations, as indicated below, are working examples of experimental results associated with some of the techniques described herein, and other plots are prophetic examples of expected experimental results.

FIGS. **1A-1B** are schematic diagrams of example RC circuits.

FIG. **2** is a schematic diagram of an example circuit that can be used as a transistor rail.

FIG. **3** is a schematic diagram of an example circuit comprising transistor rails.

FIG. **4** is a schematic diagram of an example circuit comprising transistor rails.

FIGS. **5A-5D** are plots of numerical simulations associated with circuits.

FIG. **6** is a flowchart showing a sequence of steps associated with utilizing a circuit comprising transistor rails.

FIGS. **7A-7B** are schematic diagrams of example circuits for measuring voltage fluctuations.

## DETAILED DESCRIPTION

Some integrated circuits can be operated in regime wherein fundamental thermodynamic processes characterize their behavior. In some examples, this operation can comprise driving a transistor in an integrated circuit using a voltage that is below a threshold voltage associated with the transistor such that the transistor is operating in the "sub-threshold regime" or below the sub-threshold limit. By way of example, some transistors operating in the sub-threshold regime can be driven at voltages between 0 mV and 175 mV. Some electronic devices comprising these transistors can harness thermodynamic processes to perform operations or computations.

Some circuits can comprise n-type metal-oxide-semiconductor (nMOS) or p-type metal-oxide-semiconductor (pMOS) transistors. nMOS transistors comprise semiconductors doped with an electron donor element, such as phosphorus, arsenic or antimony. pMOS transistors comprise semiconductors doped with an electron acceptor element such as boron, aluminum, or gallium.

In some implementations, voltage fluctuations measured at nodes of CMOS circuits can sample from programmable multivariate distributions that are Gaussian or substantially Gaussian. In other words, circuits can sample from a continuous distribution over a range of voltages, where the continuous distribution is substantially Gaussian. The fluctuations in some CMOS circuits are equivalent to those of regular RC networks, where the effective temperature of each resistor can be controlled. In particular, the parameters and arrangements of the pMOS and nMOS transistors composing the circuits can be chosen such that each resistor in the equivalent RC circuit has a different effective temperature. Selecting a unique effective temperature $T_{eff}$ while keeping all capacitors constant can maintain shapes of probability distributions associated with the free nodes since the covariance matrix is given by $\Sigma = k_b T_{eff} C^{-1}$, where C is the capacitance matrix. By using a large enough effective temperature, the voltage fluctuations can be made to be large enough such that the voltage fluctuations can be measured with current state-of-the-art voltage measurement devices.

A brief review of noisy RC circuits and measurement devices that can be utilized to measure voltage fluctuations is included. A family of CMOS based circuits comprising transistor rails such that a circuit can behave similarly to RC circuits with tunable conductors is presented. In some implementations, the transistor rails can comprise nMOS and pMOS transistors. Some circuits comprising transistor rails can have behaviors associated with a parameter $U_{dd}$ that is equal to $V_{dd}/V_T$, where $V_{dd}$ is a voltage applied to a transistor rail and $V_T$ is the thermal voltage. The parameter $U_{dd}$ can correspond to the voltage difference between transistor rails. In some circuits, tuning the parameter $U_{dd}$ can be associated with tuning a conductance associated with a circuit. In some examples, the parameter $U_{dd}$ can be uniform between transistor rails or identical for each pMOS and nMOS transistor such that the nodes can produce voltage fluctuations that follow a probability distribution. In some examples, $U_{dd}$ can be non-uniform. As discussed later, other parameters associated with transistor rails can be tuned.

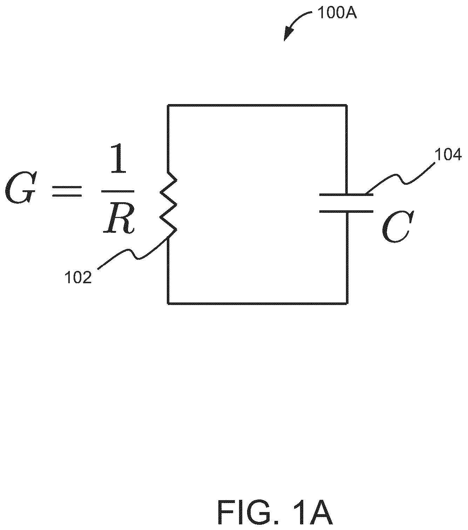

Some CMOS circuits, i.e., an apparatus, can behave similarly to resistor-capacitor circuit (RC) circuits. Some RC circuits can comprise capacitors or resistors connected in series or in parallel. FIG. 1A depicts an example RC circuit 100A comprising a resistor 102 and a capacitor 104. The capacitor 104 is associated with a capacitance $C$ and the resistor 102 is associated with a resistance $R$. The resistor 102 is also associated with a conductance $G = 1/R$. Some RC circuits can be noisy and can be characterized by thermal noise due to random motion of charge carriers, i.e., electrons within the resistor. In some examples, the random motion of charge carriers can lead to voltage fluctuations in the circuit. A stochastic differential equation (SDE) describing the voltage $V(t)$ across the capacitor in the noisy RC circuit can be given by

$$CdV = -GVdt + \sqrt{\frac{2G}{\beta}}dW, \qquad (1)$$

where $\beta = \frac{1}{k_B T}$ is the thermal noise parameter and $dW$ is a Wiener process representing white noise with zero mean and variance $dt$.

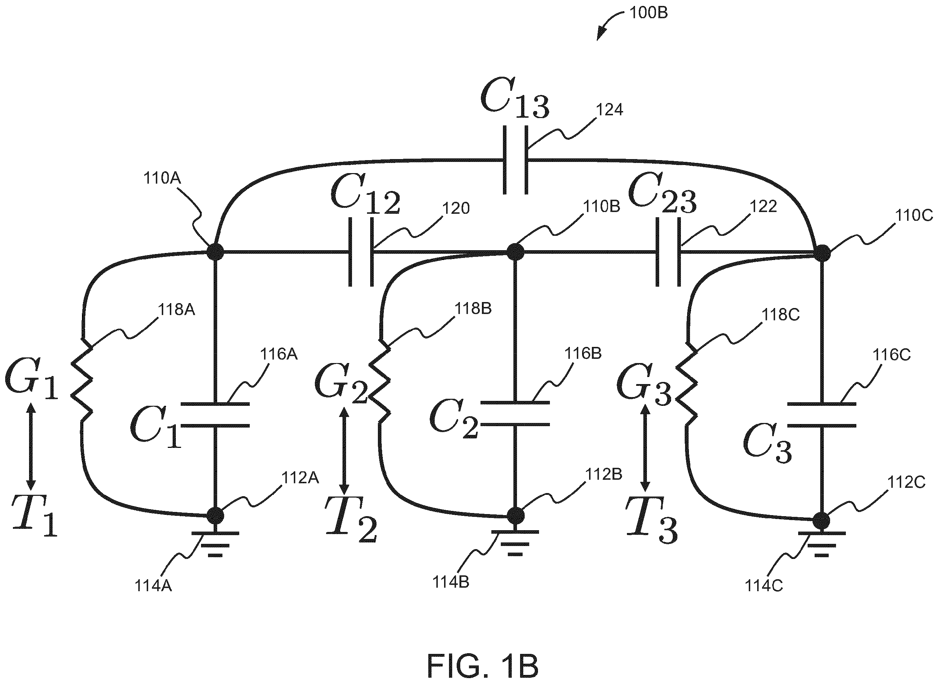

Some RC circuits can be formed from multiple sub-circuits. For instance, some RC circuits can comprise one or more of the RC circuit 100A. An example RC circuit 100B is shown in FIG. 1B. The RC circuit 100B comprises a node 110A, a node 110B, a node 110C, a node 112A a node 112B, and a node 112C. Each of the node 112A, the node 112B, and the node 112C is connected to a ground 114A, a ground 114B, and a ground 114C, respectively. The node 110A and the node 112A are connected to a capacitor 116A associated with a capacitance $C_1$ and a resistor 118A associated with a conductance $G_1$. The node 110B and the node 112B are connected to a capacitor 116B associated with a capacitance $C_2$ and a resistor 118B associated with a conductance $G_2$. The node 110C and the node 112C are connected to a capacitor 116C associated with a capacitance $C_3$ and a resistor 118C associated with a conductance $G_3$. In other words, each of the node 110A-110C and a respective node 112A-112C is connected to a respective capacitor 116A-116C associated with a respective capacitance $C_1$, $C_2$, $C_3$ and a respective resistor 118A-118C associated with a respective conductance $G_1$, $G_2$, $G_3$. The node 110A and the node 110B are connected to a capacitor 120 associated with a capacitance $C_{12}$, node 110B and node 110C are connected to a capacitor 122 associated with a capacitance $C_{23}$, and node 110A and node 110C are connected to a capacitor 124 associated with a capacitance $C_{13}$.

For some RC circuits, such as the RC circuit 100B shown in FIG. 1B, eq. (1) can be generalized to:

$$C \cdot d\mathcal{V} = -\mathcal{G} \cdot \mathcal{V} + \sqrt{2k_b \mathcal{T} \cdot \mathcal{G}} \cdot d\mathcal{W}, \qquad (2)$$

where $\mathcal{V}$ is a vector with the voltages at nodes in the circuit, $C$ is the Maxwell capacitance matrix of the circuit, and $\mathcal{T}$ and $\mathcal{G}$ are diagonal matrices containing temperatures and conductances associated with the circuit, respectively. The Maxwell capacitance matrix can be used to describe the relationship between a total charge on each conductor in a circuit and the voltages of all conductors in the circuit. $d\mathcal{W}$ is a vector of independent Wiener processes differentials.

Some RC circuits can be at thermal equilibrium such that every resistor in the RC circuit sees a bath at the same temperature. At thermal equilibrium, the probability $P(\mathcal{V})$ of obtaining a particular voltage configuration $\mathcal{V}$ can be described as the Gibbs distribution:

$$P(\mathcal{V}) \propto e^{-\beta \phi[\mathcal{V}]} \qquad (3)$$

where the potential $\phi$ is given by

$$\phi = \frac{1}{2} \mathcal{V}^T \cdot C \cdot \mathcal{V}. \qquad (4)$$

The Gibbs distribution in eq. (3) can be Gaussian, or substantially Gaussian, with covariance matrix given by $\Sigma = \beta^{-1} C^{-1}$ and zero mean.

Some devices can measure voltage fluctuations, or charge states of a circuit, such that the device can sample from a programmable mutlivariate Gaussian distribution in eq. (3) with covariance matrix given by the inverse of the capacitance matrix $C^{-1}$. Some devices can include a circuit comprising transistors and capacitors that has no work done on it such that currents are not supplied to the circuit. Such a circuit can thermalize at the Gibbs distribution as given by eq. (3). From eqs. (3) and (4), as the Maxwell capacitance matrix C increases, the scale of the voltage fluctuations can decrease by a factor proportional to $1/\sqrt{C}$, as a variance associated with a one-dimensional Gaussian can be expressed as $\sqrt{\frac{k_B T}{C}}$. As such, in some example devices, small capacitances compared to $k_B T$ can be useful to measure voltage fluctuations. More precisely, let $\delta_V$ be the resolution of the instrument which is used to measure voltage fluctuations. In some example devices, resolving thermal fluctuations can necessitate that $\sqrt{\frac{k_B T}{C}}$ be larger than $\delta_V$.

Without using the methods disclosed herein, some measurement devices can present practical limitations such that satisfying the condition $\sqrt{\frac{k_B T}{C}} > \delta_V$ is challenging. Some state-of-the-art CMOS-based devices are almost small enough for C to be small compared to $k_B T$, but even smaller devices may be necessary. As mentioned above, the strength of the voltage fluctuations decreases with capacitance, given by the relation

$$\sigma_V = \frac{1}{\sqrt{\beta C}}. \qquad (5)$$

For a circuit containing a single capacitor, if $C \approx 10aF$, then $\sigma_V \approx O(V_T)$, where the thermal voltage $V_T$ is given by

$$V_T = \frac{k_B T}{e} \qquad (6)$$

with e being the electron charge. For some current state-of-the art-devices, $C \approx O(100aF)$, which means that $\sigma_V$ is approximately between $V_T/5$ and $V_T/10$. For more complicated circuits with transistors connected to every node, $C$ increases with the system size. As such, measuring the voltage fluctuations with a high degree of accuracy can quickly become impractical. In some examples, an amplification chain comprising one or more amplifiers could be added to amplify the voltage measurement. However, an amplifier cannot add any less than 1mV of noise to the signal being measured. For instance, if the signal level is $\frac{V_T}{5}$ or $\frac{V_T}{10}$, the amplifier can only add $\frac{V_T}{25}$ to the signal. Consequently, the added signal can be insufficient to bring the signal level to a point where $\sigma_V = V_T$.

Alternatively, a circuit can be constructed such that an effective temperature associated with the circuit can be tuned such that the condition $\sqrt{\frac{k_B T}{C}} > \delta_V$ is satisfied. Recall from eqs. (3) and (4) that the Gibbs distribution can be expressed as:

$$P \propto e^{-\frac{1}{2k_B T} V^T C V}, \qquad (7)$$

with $\sigma_V = \sqrt{k_B T / C}$. As such, by raising the effective temperature of the heat bath, the voltage fluctuations can be amplified while preserving the shape of the distribution since the covariance matrix $\Sigma = k_b T C^{-1}$ is only multiplied by a factor. Equivalently, by keeping $C$ constant but raising the effective temperature, the eigenvalues associated with $\Sigma$ can be amplified by the same amount.

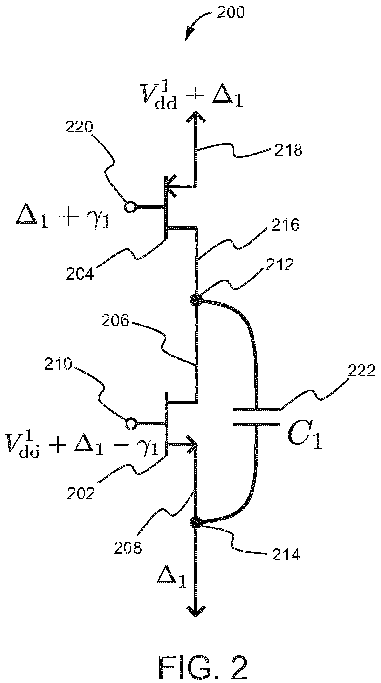

FIG. 2 depicts an example circuit 200 that can allow for a conductance to be tuned while maintaining a constant Maxwell capacitance matrix such that the effective temperature is indirectly tuned. The circuit 200 is an example of a transistor rail comprising a first transistor 202 and a second transistor 204. The first transistor 202 comprises a first terminal 206, a second terminal 208, and a third terminal 210. The first terminal 206 is connected to a first node 212 and the second terminal 208 is connected to a second node 214. The second transistor 204 comprises a fourth terminal 216, a fifth terminal 218, and a sixth terminal 220. The fourth terminal 216 is connected to the first node 212. A capacitor 222 is connected to the first node 212 and the second node 214. In some implementations, the first transistor 202 or the second transistor 204 can each comprise a fourth terminal. In some implementations, the first transistor 202 can be a nMOS transistor and the second transistor 204 can be a pMOS transistor. In such implementations, the circuit 200 is equivalent to the RC circuit 100A using nMOS and pMOS components.

One or more voltage sources (not shown) can be configured to apply a first voltage $V_1$ to the fifth terminal 218, a second voltage $V_2$ to the sixth terminal 220, a third voltage $V_3$ to the third terminal 210, and a fourth voltage $V_4$ to the second node 214. In some implementations, the first voltage, the second voltage, the third voltage, and the fourth voltage can be expressed using the following parameters:

$$V_1 = V_{dd}^1 + \Delta_1 \qquad (8)$$

$$V_2 = \Delta_1 + \gamma_1 \qquad (9)$$

$$V_3 = V_{dd}^1 + \Delta_1 - \gamma_1 \qquad (10)$$

$$V_4 = \Delta_1, \qquad (11)$$

such that $V_1 + V_4 = V_2 + V_3$. In some examples, the sum $V_1 + V_4$ can be within 10% of the sum $V_2 + V_3$.

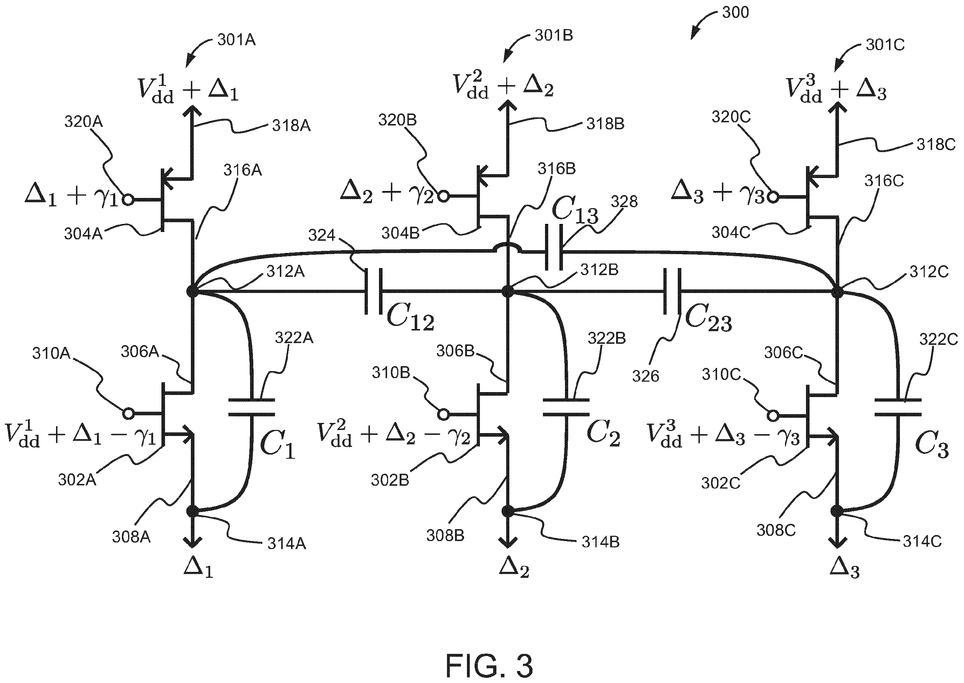

An example implementation of the RC circuit 100B using nMOS and pMOS components is shown in FIG. 3. The example circuit 300 depicted in FIG. 3 comprises a plurality of transistor rails 301A-301C comprising a first transistor rail 301A, a second transistor rail 301B, and a third transistor rail 301C. The first transistor rail 301A comprises a first transistor 302A and a second transistor 304A, the second transistor rail 301B comprises a first transistor 302B and a second transistor 304B, and the third transistor rail 301C comprises a first transistor 302C and a second transistor 304C. In other words, each transistor rail of the plurality of transistor rails 301A-301C comprises a respective first transistor 302A-302C and second transistor 304A-304C.

The first transistor 302A comprises a first terminal 306A, a second terminal 308A, and a third terminal 310A. The first transistor 302B comprises a first terminal 306B, a second terminal 308B, and a third terminal 310B. The first transistor 302C comprises a first terminal 306C, a second terminal 308C, and a third terminal 310C. In other words, each first transistor 302A-302C comprises a respective first terminal 306A-306C, second terminal 308A-308C, and third terminal 310A-310C. Each of the first terminal 306A, the first terminal 306B, and the first terminal 306C is connected to a first node 312A, a first node 312B, and a first node 312C, respectively. Each of the second terminal 308A, the second terminal 308B, and the second terminal 308C is connected to a second node 314A, a second node 314B, and a second node 314C, respectively. In some implementations, each of the first transistor 302A, the first transistor 302B, and the first transistor 302C can be an nMOS transistor and each of the second transistor 304A, the second transistor 304B, and the second transistor 304C can be a pMOS transistor.

The second transistor 304A comprises a fourth terminal 316A, a fifth terminal 318A, and a sixth terminal 320A. The second transistor 304B comprises a fourth terminal 316B, a fifth terminal 318B, and a sixth terminal 320B. The second transistor 304C comprises a fourth terminal 316C, a fifth terminal 318C, and a sixth terminal 320C. In other words, each second transistor 304A-304C comprises a respective fourth terminal 316A-316C, fifth terminal 318A-318C, and sixth terminal 320A-320C. Each of the fourth terminal 316A, the fourth terminal 316B, the fourth terminal 316C is connected to the first node 312A, the first node 312B, and the first node 312C, respectively. Each transistor rail of the plurality of transistor rails 301A-301C comprises a capacitor 322A, a capacitor 322B, and a capacitor 322C, respectively. Each of the capacitor 322A, the capacitor 322B, and the capacitor 322C is connected to a first node 312A, a first node 312B, and a first node 312C, respectively, and a second node 314A, a second node 314B, and a second node 314C, respectively. Each first node 312A-312C is connected to a first node 312A-312C of two different respective transistor rails of the plurality of transistor rails 301A-301C by a capacitor 324, a capacitor 326, or a capacitor 328, respectively.

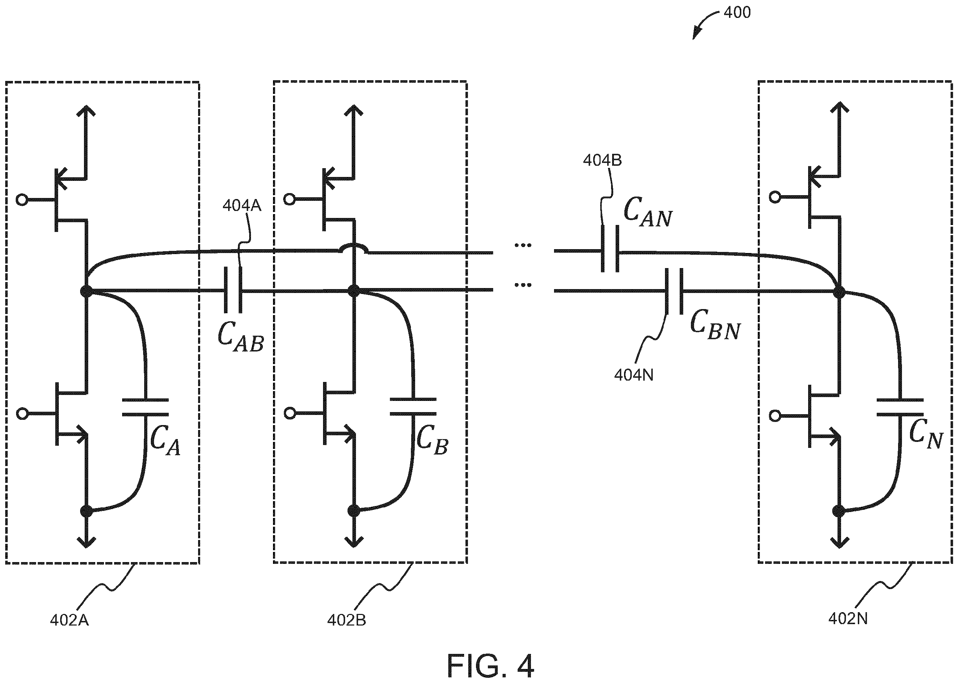

In some implementations, a circuit can comprise a plurality of transistor rails. FIG. 4 depicts an example circuit 400 comprising a plurality of transistor rails 402A-402N, i.e., a transistor rail 402A, a transistor rail 402B, and a transistor rail 402N. Each transistor rail of the plurality of transistor rails 402A-402N comprises a similar configuration to the circuit 200, i.e., the transistor rail, and each transistor rail of the plurality of transistor rails 301A-301C. The first node of each transistor rail can be connected to a first node of any number of other respective transistor rails by a respective capacitor 404A-404N. The different pairs of first nodes of respective transistor rails that are connected by a capacitor can correspond to a mutual capacitance in an associated Maxwell capacitance matrix of the circuit. In an implementation in which there are nonzero mutual capacitance values for every element of the capacitance matrix, each transistor rail would have its first node connected by a respective capacitor to first nodes every other transistor rail in the circuit.

In some implementations, external circuitry can be configured to interact with a circuit architecture or a circuit, or portions thereof. For instance, some external circuitry can interact with a circuit architecture by applying voltages to or reading voltages from a circuit architecture or portions thereof. For instance, control circuitry can be configured to apply control signals or generate voltages to be applied to a circuit. In some examples, readout circuitry configured to read, sample, and/or store voltages from a circuit. In some implementations, circuitry configured to apply control signals to a circuit architecture, or portions thereof, can be positioned on a separate integrated circuit chip or device as the circuit architecture. In some examples, control signals applied to a circuit or signals produced by a circuit can be weak. In some implementations, to mitigate weak signals, circuitry configured to apply control signals to a circuit architecture, or portions thereof, can be positioned in proximity to the circuit architecture, i.e., on the same integrated circuit chip or device that comprises the circuit architecture. In some implementations, circuitry configured to readout signals from a circuit architecture, or portions thereof, can be positioned in proximity to the circuit architecture, i.e., on the same integrated circuit chip or device that comprises the circuit architecture. Positioning one or both of the readout circuitry or the control circuitry in proximity to a circuit architecture can be useful to mitigate losses associated with transmitting weak signals over larger distances.

In some implementations, CMOS-based circuits can be modeled as RC circuits with tunable conductances, such that each resistor sees a different temperature environment. The circuit 200, each transistor rail of the plurality of transistor rails 301A-301C, or each transistor rail of the plurality of transistor rails 402A-402C is associated with the parameters:

- $\gamma$: Can be a tunable conductor for each transistor.

- $\Delta$: Can shift a voltage range of the circuit, as the ground, or the voltage applied to the second node, is set to $\Delta$ and each

transistor rail is associated with a voltage $V_{dd} + \Delta$.

- $V_{dd}$: Corresponds to the voltage difference from rail-to-rail.

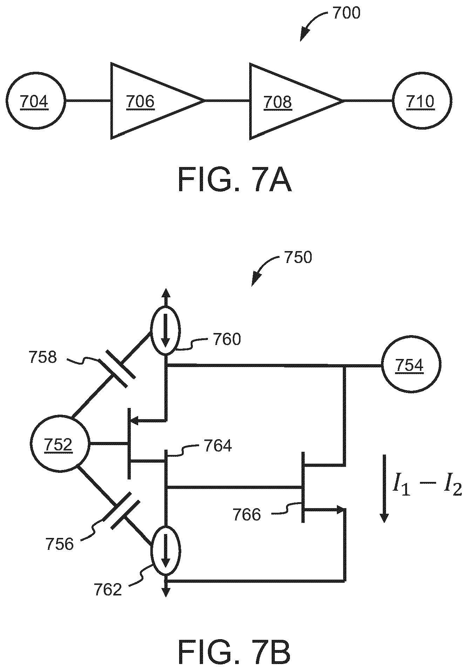

In some implementations, tuning one or more of $\gamma$ or $\Delta$ can be associated with tuning the conductance. More specifically, as shown in FIGS. 2-3, each of the fifth terminals of a respective transistor rail is associated with a voltage $V_{dd}^i + \Delta_i$, each of the sixth terminals of a respective transistor rail is associated with a voltage $\Delta_i + \gamma_i$, each of the third terminals of a respective transistor rail is associated with voltage $V_{dd}^i + \Delta_i - \gamma_i$, and each of the second nodes of a respective transistor rail is associated with a voltage $\Delta_i$. By providing each transistor rail in the circuit 200, the circuit 300, and the circuit 400 with a respective set of voltages at each of the fifth terminal, sixth terminal, third terminal, and second node, voltage fluctuations at each first node can be obtained. Further, by tuning the voltages provided to each circuit, the size of the voltage fluctuations received can be tuned as desired. The voltage fluctuations between the first node and the second node of each circuit can then be measured to sample from a Gaussian distribution. An example circuit for measuring voltage fluctuations is depicted in FIG. 7A. For the circuit 300 and the circuit 400, a vector of voltage distributions at each node can be produced, allowing for the sampling of a multivariate Gaussian distribution. In some implementations, obtaining these voltage fluctuations can be associated a cost of inputting energy into the terminals of the transistors and a cost of measuring the voltages.

Without intending to be bound by theory, the following is an example of a theoretical model for illustrating features associated with the tunable effective temperatures of the circuit 300 and the circuit 400. A continuum approximation to the SDE of the circuit, also known as the Kramers-Moyal expansion, can be written as:

$$\sum_j C_{kj} dV_j = -G_k \sinh\left(\frac{V_k - v_k}{V_T}\right) dt + \sqrt{q_e G_k \left(\cosh\left(\frac{V_k - v_k}{V_T}\right) + e^{V_{dd}^k/2V_T}\right)} dW_k \qquad (12)$$

where

$$G_k = 2I_0 e^{-V_{th}/nV_T} e^{-\gamma_k/(V_T n)} e^{(2-n)V_{dd}^k/(2V_T n)}, \qquad (13)$$

$$v_k = V_{dd}^k/2 + \Delta_k, \qquad (14)$$

and $q_e$ is the positive electron charge. From eq. (13), the effective conductance $G_k$ is a function of the parameters $\gamma_k$ and $V_{dd}^k$. As long as the fluctuations are relatively small compared to $V_T$, eq. (12) can be linearized. The cosh term in eq. (12) has no linear term, but the added constant $e^{V_{dd}^k/2V_T}$ can be much larger than the cosh term, even for moderate values of $V_{dd}^k/V_T$. As such, the linearization:

$$\frac{\cosh\left(\frac{V_k - v_k}{V_T}\right) + e^{V_{dd}^k/2V_T}}{2} \to \frac{1 + e^{V_{dd}^k/2V_T}}{2} \qquad (15)$$

is accurate. The sinh term can be linearized

$$\sinh\left(\frac{V_k - v_k}{V_T}\right) \to \frac{V_k - v_k}{V_T} \qquad (16)$$

The linearized version of eq. (12) can then given by

$$\sum_j C_{kj} dV_j = -G_k \left[ \frac{V_k - v_k}{V_T} \right] dt + \sqrt{\frac{q_e G_k}{\beta_k}} dW_k \qquad (17)$$

which is the same type of SDE that is obtained from a noisy RC circuit. The effective temperature can be defined as

$$\frac{1}{\beta_k} = k_B T_k = \frac{1 + e^{V_{dd}^k / 2V_T}}{2}. \qquad (18)$$

From eq. (18), a higher $V_{dd}^k / V_T$ can be associated with a higher effective temperature, as the effective temperature can grow exponentially with $V_{dd}^k / V_T$.

The steady state of eq. (17) can be a Gaussian distribution centered at zero. In some examples, the steady state in voltage space can be a Gaussian distribution with a programmable mean $\mu = v/V_T$ (since $V_k = V_{dd}^k / V_T - v_k / V_T$). As such, $\mu_k$ can allow for the biasing of each voltage.

In some implementations, $V_{dd}^k$ can be the same for each first node of a respective transistor rail. In some examples, if $V_{dd}^k$ is the same for each transistor rail, the system can be equivalent to an equilibrium RC circuit such that:

$$\beta = \frac{1 + e^{\frac{V_{dd}}{2V_T}}}{2}. \qquad (19)$$

The steady state distribution corresponds to a Boltzmann distribution with

$$P \propto e^{-\beta(U - \mu)^T B (U - \mu)} \qquad (20)$$

where $\beta$ is the programmable temperature, $U = V/V_T$, $B$ corresponds to the programmable covariance matrix with $B = C^{-1}$, and $\mu = v/V_T$ is the programmable mean. Additionally, if $U_{dd}$ is uniform, $\Delta$ can be the same rail-to-rail. In this setting, the relative capacitance values of the capacitors in each transistor rail or the capacitors connecting each transistor rail can be used to tune the effective temperature.

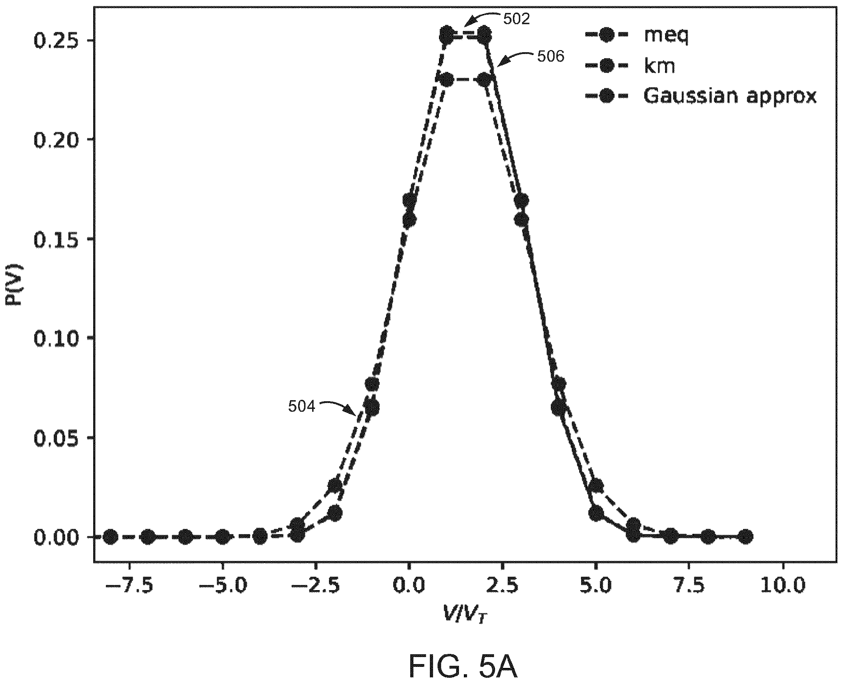

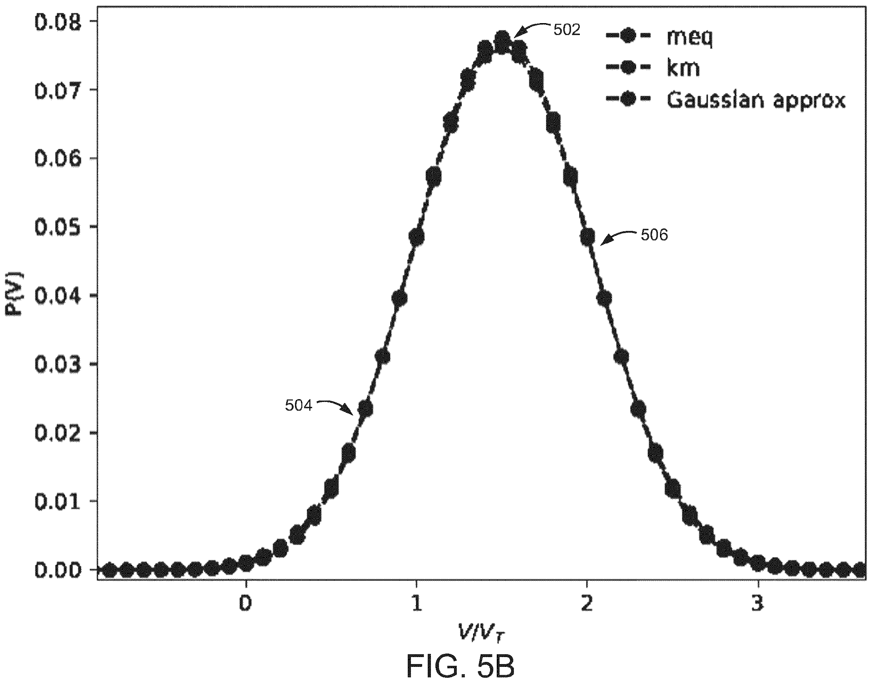

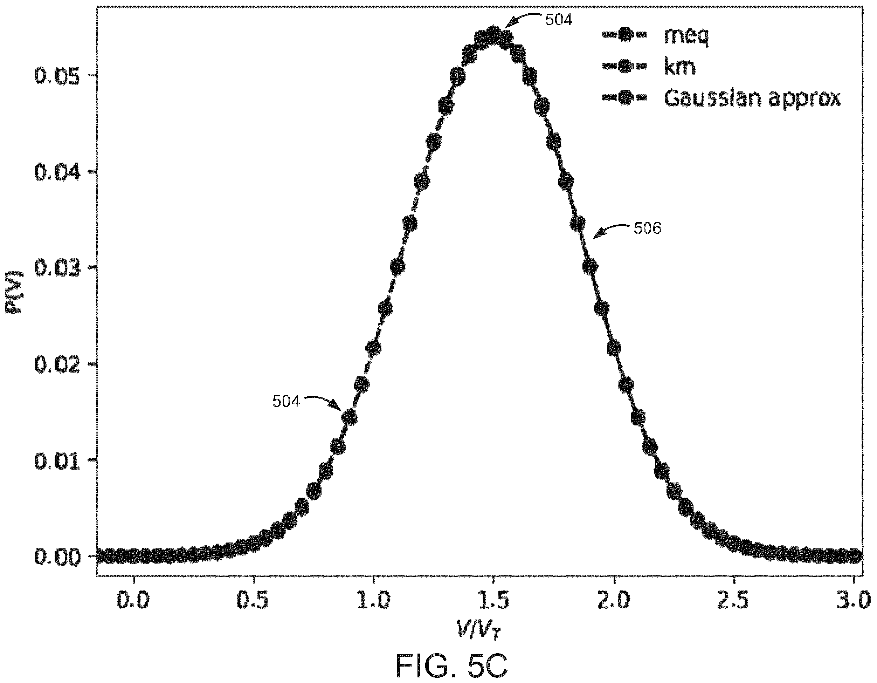

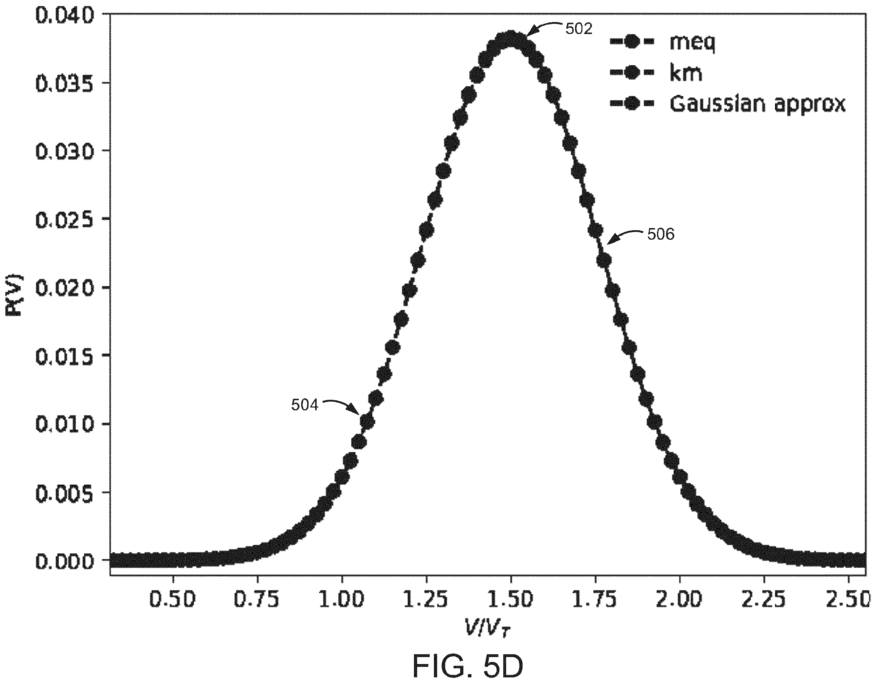

FIGS. 5A-5D depict plots of numerical simulations associated with a solution to eq. (12) with a linear approximation that can lead to the distribution in eq. (20) in the case where $V_{dd}$ is uniform across each transistor rail. In some implementations, if $\Omega$ (the maximum eigenvalue of the capacitance matrix) is not too small, the linear approximation can be an approximation to the full solution in eq. (12). FIGS. 5A-5D each depict numerical simulation of $P(V)$ as a function of $V/V_T$. Each trace 502 is calculated using eq. (12), each trace 504 is calculated using eq. (20) where the linear approximation leading to eq. (17) was performed, and each trace 506 is a solution to the Kramers-Moyal expansion. Each plot is calculated using a same value of $V_{dd}$ and a different value of $\Omega$, which corresponds to the maximum eigenvalue of the capacitance matrix. FIG. 5A is calculated using $V_{dd} = 3.0$, $\Omega = 1.0$, FIG. 5B is calculated using $V_{dd} = 3.0$, $\Omega = 10.0$, FIG. 5C is calculated using $V_{dd} = 3.0$, $\Omega = 20.0$, and FIG. 5D is calculated using $V_{dd} = 3.0$, $\Omega = 40.0$. As shown by the overlap of each trace 502, 504, 506, the linear approximation can be used as long as the tails of the distribution stay within $V_T$ of the mean.

In some implementations, the amplification cost for obtaining voltage samples from the circuits depicted in FIGS. 2-4 can be lower than voltage samples obtained from a standard digital sampling routine. A characteristic energy scale of digital computing can be associated with the charging energy of the transistor parasitic capacitors, which can be $\frac{1}{2}CV^2$.

In some examples, transistors run at 1V such that the characteristic energy can be $\frac{1}{2}C$. In some implementations, the amplification cost using the circuits shown in FIGS. 2-4 can be roughly 10% when the capacitance reaches a few hundred attofarads. Without using the methods disclosed herein, in some implementations of digital Gaussian sampling, tens to hundreds of thousands of transistors can be discharged per sample. In contrast, the circuits depicted in FIGS. 2-4 can utilize several transistors. As such, in some implementations, using the circuits depicted in FIGS. 2-4 to generate voltage samples can be associated with a factor of $10^5$ to $10^6$ in energy savings.

In some implementations, each $V_{dd}$ associated with a transistor rail can be non-uniform. In such implementations, each resistor can see an environment with a different temperature. The steady-state can be Gaussian, but the covariance can depend on conductances and effective temperatures in a more complicated way. The steady state distribution can be expressed as:

$$P \propto e^{-\frac{1}{2}(U-\mu)^T B \Sigma^{-1}(U-\mu)}, \qquad (21)$$

where

$$\mathcal{G}\mathcal{B}^{-1} = \mathcal{G}B^{-1}\Sigma + \Sigma\mathcal{G}B^{-1}, \qquad (22)$$

with

$$\mathcal{G}_{jj} = G_j \qquad (23)$$

$$\mathcal{B}_{jj} = \beta_j \qquad (24)$$

The covariance matrix can be given by the solution to eq. (22), which is known as the Lyapunov equation.

In some implementations, the capacitances can be fixed and elements of the covariance matrix $\Sigma$ can be tuned by tuning the conductances and effective temperatures of the circuit in such a way that the solution to eq. (22) results in the desired covariance matrix. The example circuit 300 can be a latent variable based sampler. In some examples, the first transistor rail 301A and the third transistor rail 301C can sample from a two-dimensional Gaussian, whereas the second transistor rail 301B can be used to tune the elements of the covariance matrix by ensuring that $\mathcal{G}$ and $\mathcal{B}$ in eq. (22) are non-trivial.

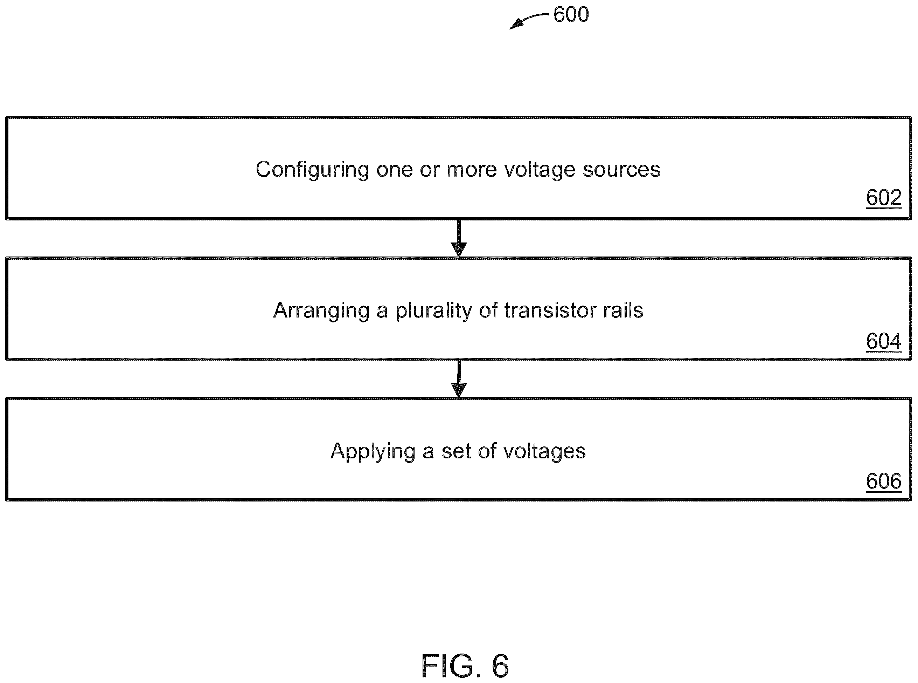

FIG. 6 depicts a flowchart for an example method 600 for sampling from a Gaussian distribution. The method comprises configuring 602 one or more voltage sources, arranging 604 a plurality of transistor rails, each transistor rail comprising a first transistor comprising a first terminal, a second terminal, and a third terminal, wherein the first terminal is connected to a first node and the second terminal is connected to a second node, a second transistor comprising a fourth terminal, a fifth terminal, and a sixth terminal, wherein the fourth terminal is connected to the first node, and a first capacitor connected to the first node and the second node wherein the first node of each transistor rail is connected to a first node of two different respective transistor rails by two different respective capacitors. The method 600 also comprises applying 606 to each transistor rail a respective set of voltages. In some implementations, the method 600 can further comprise measuring a voltage difference between the first node and the second node of each of the transistor rails.

Some circuits that can sample a Gaussian distribution can incorporate a measurement circuit to measure voltage fluctuations. Some measurement circuits can be non-destructive. Some circuits capable of performing non-destructive measurements can be configured such that the measurements do not alter a voltage sample that is being recorded by more than 1% during a particular non-destructive voltage measurement. FIG. 7A depicts an example circuit 700 that can perform a non-destructive measurement of a voltage node 704. The circuit 700 contains a sense amp 706, a gain amp 708, and an output node 710. In some example circuits, the gain amp 708 can be associated with a gain close to 0dB. FIG. 7B depicts an example circuit 750 that can be utilized as a sense amp 706 in circuit 700. The circuit 750 comprises a node 752 associated with a voltage $V_{in}$ and a node 754 associated with a voltage $V_{out}$. The circuit 750 also comprises a capacitor 756 associated with a capacitance $C_{gd}$, a capacitor 758 associated with a capacitance $C_{gs}$, a current source 760 associated with a current $I_1$, and a current source 762 associated with a current $I_2$ The circuit 750 also comprises a pnp transistor 764 and an npn transistor 766. A source-follower configuration with feedback as the buffer can also be used. The example circuit 750 has two capacitances, namely $C_{gs}$ and $C_{gd}$ that load the state of the node being measured. In a source-follower configuration, the input and output nodes are the same and the $C_{gs}$ capacitance is not seen by the input node. A capacitor can be seen as a load if it needs to be charged or discharged. If the voltage across the capacitor doesn't charge, then there is no charging or discharging and hence it is not loading which is what happens for $C_{gs}$ since the input and output of the sense amp are the same. This input and output can be similar when a gain is close to 0dB.

In some implementations, using circuits comprising transistor rails can comprise a calibration step wherein a voltage distribution is measured for each voltage of a range of voltages applied to the transistor rails. A circuit can then be configured to produce desired distributions based on the calibration step.

In some implementations, a circuit architecture can be formed as part of a system. A system can be implemented in various configurations, including as a single apparatus or as a combination of one or more apparatuses that collectively perform the functions of a system. In some examples, the one or more apparatuses can form a device, i.e., a system-on-a-chip, or the one or more apparatuses can be separate devices.

In some implementations, a system can be formed from one or more integrated circuit (IC) chips comprising portions of a circuit architecture. Some circuit architectures can be distributed across multiple chips or consolidated onto a single chip. Some chips can comprise multiple layers of material. In some examples, portions of a circuit architecture can be formed across several layers of devices.

Some systems can comprise analog, digital, or mixed-signal circuitry configured to perform functions such as signal processing, voltage regulation, or data acquisition. Some systems can comprise interface or control circuitry configured to perform functions such as applying bias voltages, measuring voltages, or interfacing with components of the circuit. In some examples, control circuitry can be implemented in one or more dedicated regions of an IC, or distributed throughout a circuit architecture. In some examples, control circuitry can comprise components such as a field-programmable gate array (FPGA), an application specific integrated circuit (ASIC), one or more processors or processor cores, including central processing unit(s) (CPU(s)) and/or graphics processing unit(s) (GPU(s)), or other computing devices or modules capable of executing a program (e.g., software and/or firmware) comprising instructions or other compiled or executable code. The electronic circuitry can also include at least one data storage system (e.g., including volatile and non-volatile memory, and/or storage media). The program may be provided on a computer-readable storage medium, or delivered over a communication medium such as a wired or wireless network, to a device module where it can be stored and eventually executed when read by the device to perform the procedures of the program.

In some implementations, portions of a circuit architecture and control circuitry can be arranged in a flip-chip configuration to allow for three-dimensional integration of multiple chips or substrates. Some flip-chip configurations comprise conductive structure such as wire bonds, microbumps, or vias to facilitate electrical communication between multiple layers or chips.

While the disclosure has been described in connection with certain embodiments, it is to be understood that the disclosure is not to be limited to the disclosed embodiments but, on the contrary, is intended to cover various modifications and equivalent arrangements included within the scope of the appended claims, which scope is to be accorded the broadest interpretation so as to encompass all such modifications and equivalent structures as is permitted under the law.

**Claims**

1. An apparatus comprising:

   one or more voltage sources;
   a first transistor rail comprising

      a first transistor comprising a first terminal, a second terminal, and a third terminal, wherein the first terminal is connected to a first node and the second terminal is connected to a second node,
      a second transistor comprising a fourth terminal, a fifth terminal, and a sixth terminal, wherein the fourth terminal is connected to the first node, and
      a first capacitor connected to the first node and the second node;

   wherein a voltage source is configured to apply a first voltage, $V_1$, to the fifth terminal;
   wherein a voltage source is configured to apply a second voltage, $V_2$, to the sixth terminal;
   wherein a voltage source is configured to apply a third voltage, $V_3$, to the third terminal;
   wherein a voltage source is configured to apply a fourth voltage, $V_4$, to the second node; and
   wherein $V_1 + V_4$ is within 10% of $V_2 + V_3$.

2. The apparatus of claim 1, further comprising a measurement circuit configured to measure one or more voltage differences between the first node and the second node.

3. An apparatus comprising:

   one or more voltage sources;
   a plurality of transistor rails, each transistor rail of the plurality of transistor rails

      comprising
      a first transistor connected to a first node and a second node,
      a second transistor connected to the first node, and

a first capacitor connected to the first node and the second node;

wherein the first node of each transistor rail of the plurality of transistor rails is connected to a first node of two different respective transistor rails of the plurality of transistor rails by two different respective capacitors;
wherein one or more voltage sources are configured to apply a respective set of voltages to each transistor rail of the plurality of transistor rails.

4. The apparatus of claim 3, wherein the first transistor comprises a first terminal connected to the first node, a second terminal connected to the second node, and a third terminal, the second transistor comprises a fourth terminal connected to the first node, a fifth terminal, and a sixth terminal, and a set of voltages applied to a transistor rail of the plurality of transistor rails comprises

a first voltage applied to the first terminal,
a second voltage applied to the sixth terminal,
a third voltage applied to the third terminal, and
a fourth voltage applied to the second node.

5. The apparatus of any one of claims 1 to 4, wherein the second voltage is lower than a threshold voltage of the second transistor and the third voltage is lower than a threshold voltage of the first transistor.

6. The apparatus of claim 3, further comprising a plurality of measurement circuits, where each measurement circuit of the plurality of measurement circuits is configured to measure a voltage difference between a first node and second node of a respective transistor rail of the plurality of transistor rails.

7. The apparatus of any one of claims 1 to 6, wherein each first transistor is an n-type metal-oxide-semiconductor transistor and each second transistor is a p-type metal-oxide-semiconductor transistor.

8. A method comprising:

configuring one or more voltage sources;
arranging a plurality of transistor rails, each transistor rail of the plurality of transistor rails comprising

a first transistor comprising a first terminal, a second terminal, and a third terminal, wherein the first terminal is connected to a first node and the second terminal is connected to a second node,
a second transistor comprising a fourth terminal, a fifth terminal, and a sixth terminal, wherein the fourth terminal is connected to the first node, and
a first capacitor connected to the first node and the second node,
wherein the first node of each transistor rail of the plurality of transistor rails is connected to a first node of each of two different respective transistor rails of the plurality of transistor rails by two different respective capacitors; and

applying, to each transistor rail of the plurality of transistor rails, a respective set of voltages.

9. The method of claim 8, wherein a set of voltages applied a transistor rail of the plurality of transistor rails comprises

a first voltage applied to the first terminal,
a second voltage applied to the sixth terminal,
a third voltage applied to the third terminal, and
a fourth voltage applied to the second node.

10. The method of claim 9, wherein, for each transistor rail of the plurality of transistor rails, a difference of the first voltage applied to the first terminal and the fourth voltage applied to the second node is within 10% of a difference of the first voltage applied to the first terminal and the fourth voltage applied to the second node in each set of voltages applied to each other transistor rail of the plurality of transistor rails.

11. The method of claim 9 or 10, wherein for each transistor rail of the plurality of transistor rails, the second voltage is lower than a threshold voltage of the second transistor and the third voltage is lower than a threshold voltage of the respective first transistor.

12. The method of claim 9, 10 or 11, wherein for each transistor rail of the plurality of transistor rails, a sum of the first voltage applied to the first terminal with the fourth voltage applied to the second node is within 10% of a sum of the second voltage applied to the sixth terminal and the third voltage applied to the third terminal.

13. The method of any one of claims 8 to 12, further comprising measuring a plurality of voltage differences between the first node and the second node of each transistor rail of the plurality of transistor rails.

14. The method of any one of claims 8 to 13, further comprising measuring a voltage difference between a first node and the second node of one transistor rail of the plurality of transistor rails while tuning the sets of voltages applied to each other transistor rail of the plurality of transistor rails, wherein tuning the sets of voltages comprises applying, to each transistor rail of the plurality of transistor rails,

 a first voltage applied to the first terminal,
 a second voltage applied to the sixth terminal,
 a third voltage applied to the third terminal, and
 a fourth voltage applied to the second node.

15. The method of any one of claims 8 to 14, further comprising measuring, at each first node of each transistor rail of the plurality of transistor rails, a voltage distribution that is substantially Gaussian.

100A

104

102

$$G = \frac{1}{R}$$

C

FIG. 1A

FIG. 1B

FIG. 2

FIG. 3

EP 4 693 903 A1

EP 4 693 903 A1

FIG. 4

FIG. 5A

meq
km
Gaussian approx

502
506
504

$P(V)$

$V/V_T$

0.25
0.20
0.15
0.10
0.05
0.00

-7.5  -5.0  -2.5  0.0  2.5  5.0  7.5  10.0

FIG. 5B

EP 4 693 903 A1

FIG. 5C

EP 4 693 903 A1

FIG. 5D

Configuring one or more voltage sources

602

Arranging a plurality of transistor rails

604

Applying a set of voltages

606

600

EP 4 693 903 A1

FIG. 6

FIG. 7A

FIG. 7B

| Europäisches Patentamt European Patent Office Office européen des brevets | **EUROPEAN SEARCH REPORT** | **Application Number** EP 25 19 0662 |
| --- | --- | --- |

## DOCUMENTS CONSIDERED TO BE RELEVANT

| Category | Citation of document with indication, where appropriate, of relevant passages | Relevant to claim | CLASSIFICATION OF THE APPLICATION (IPC) |
| --- | --- | --- | --- |
| A | US 2020/364032 A1 (HEKMATSHOARTABARI BAHMAN [US] ET AL) 19 November 2020 (2020-11-19) * paragraph [0064]; figure 12 * * paragraphs [0071], [0072]; figure 14 * * paragraph [0082]; figure 18 * ----- | 1-15 | INV. H03K3/84 ADD. G06F7/58 |
| A | DE 196 18 098 C1 (SIEMENS AG [DE]) 5 June 1997 (1997-06-05) * column 2, lines 54-58; figure 2 * * column 3, lines 7-14 * ----- | 1,2 | |
| A | US 2011/169580 A1 (DODRILL JAMES [US]) 14 July 2011 (2011-07-14) * paragraph [0030]; figure 3 * ----- | 1-15 | |

| | **TECHNICAL FIELDS SEARCHED (IPC)** |
| --- | --- |
| | H03K G06F |

The present search report has been drawn up for all claims

| Place of search | Date of completion of the search | Examiner |
| --- | --- | --- |
| Munich | 16 December 2025 | Martínez Martínez, J |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

**Application Number**

EP 25 19 0662

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

## LACK OF UNITY OF INVENTION

The Search Division considers that the present European patent application does not comply with the requirements of unity of invention and relates to several inventions or groups of inventions, namely:

see sheet B

☐ All further search fees have been paid within the fixed time limit. The present European search report has been drawn up for all claims.

☒ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☐ None of the further search fees have been paid within the fixed time limit. The present European search report has been drawn up for those parts of the European patent application which relate to the invention first mentioned in the claims, namely claims:

☐ The present supplementary European search report has been drawn up for those parts of the European patent application which relate to the invention first mentioned in the claims (Rule 164 (1) EPC).

Europäisches
Patentamt
European
Patent Office
Office européen
des brevets

**LACK OF UNITY OF INVENTION
SHEET B**

Application Number

EP 25 19 0662

The Search Division considers that the present European patent application does not comply with the requirements of unity of invention and relates to several inventions or groups of inventions, namely:

**1. claims: 1-15**

All claims searched

**1.1. claims: 1, 2**

The first subject (Claims 1 and 2) relates to a rail circuit comprising two transistors in series with a capacitor between two nodes of one of the transistors such that the sum of voltages applied to two nodes of the circuit is within 10% of the sum of the voltages applied to two other nodes.

**1.2. claims: 3-15**

The second subject (Claims 3 to 15) relates to a circuit comprising a plurality of rail circuits each comprising two transistors in series with a capacitor between two nodes of one of the transistors, the rail circuits being capacitively coupled to each other.

---

Please note that all inventions mentioned under item 1, although not necessarily linked by a common inventive concept, could be searched without effort justifying an additional fee.

## ANNEX TO THE EUROPEAN SEARCH REPORT
## ON EUROPEAN PATENT APPLICATION NO.

EP 25 19 0662

This annex lists the patent family members relating to the patent documents cited in the above-mentioned European search report.
The members are as contained in the European Patent Office EDP file on
The European Patent Office is in no way liable for these particulars which are merely given for the purpose of information.

16-12-2025

| Patent document cited in search report | Publication date | Patent family member(s) | Publication date |
|---|---|---|---|
| US 2020364032 A1 | 19-11-2020 | CN 113692571 A | 23-11-2021 |
| | | DE 112020001000 T5 | 09-12-2021 |
| | | JP 7482903 B2 | 14-05-2024 |
| | | JP 2022532601 A | 15-07-2022 |
| | | US 2020364032 A1 | 19-11-2020 |
| | | WO 2020229996 A1 | 19-11-2020 |
| DE 19618098 C1 | 05-06-1997 | BR 9708977 A | 03-08-1999 |
| | | CN 1217834 A | 26-05-1999 |
| | | DE 19618098 C1 | 05-06-1997 |
| | | EP 0897613 A1 | 24-02-1999 |
| | | JP H11509707 A | 24-08-1999 |
| | | KR 20000010804 A | 25-02-2000 |
| | | WO 9742706 A1 | 13-11-1997 |
| US 2011169580 A1 | 14-07-2011 | US 2011169580 A1 | 14-07-2011 |
| | | WO 2011085138 A1 | 14-07-2011 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 63680687